# EUROPEAN PATENT SPECIFICATION

(11) **EP 4 064 272 B1**
(45) Date of publication and mention of the grant of the patent: **30.07.2025**
(21) Application number: 20890153.8
(22) Date of filing: 02.11.2020
(51) Int. Cl.: G10H 1/34, G01D 5/20, G10H 1/055, H03K 17/97, H03K 17/972

(54) **DETECTION SYSTEM, MUSICAL PERFORMANCE OPERATING DEVICE, AND KEYBOARD INSTRUMENT**
DETEKTIONSSYSTEM, BETÄTIGUNGSVORRICHTUNG FÜR MUSIKALISCHE DARBIETUNG UND TASTENINSTRUMENT
SYSTÈME DE DÉTECTION, DISPOSITIF OPÉRANT UNE PRESTATION MUSICALE, ET INSTRUMENT À CLAVIER

(30) Priority: 20.11.2019 JP 2019209680
(43) Date of publication of application: 28.09.2022
(73) Proprietor: YAMAHA CORPORATION, Hamamatsu-shi Shizuoka, 430-8650 (JP)
(72) Inventor: MIYOSHI, Shunsuke, Hamamatsu-shi, Shizuoka 430-8650 (JP)
(74) Representative: Kehl, Ascherl, Liebhoff & Ettmayr Patentanwälte Partnerschaft mbB
(86) International application number: PCT/JP2020/041035
(87) International publication number: WO 2021/100448

(56) References cited:
- EP-B1- 0 259 488
- WO-A1-2019/122867
- JP-A- 2008 249 852
- JP-A- H03 223 796
- JP-A- S58 154 909
- JP-A- S6 411 300
- US-A- 5 449 858
- US-A1- 2014 245 877

## Description

### Technical Field

The present disclosure relates to techniques for detecting movements of a movable member.

### Background Art

A variety of techniques have been proposed for detecting displacement of a movable member such as a key of a musical keyboard instrument. Patent Document 1 discloses a configuration for detecting a displacement of a movable member by use of an excitation coil and a position detection coil disposed on a fixed member, and an excitable coil disposed on the movable member movable to the fixed member. The excitation coil, the position detection coil, and the excitable coil are each formed in a ring shape, and they are parallel to the direction of a movement of the movable member. In the above configuration, supply of a cyclic signal causes generation of a magnetic field in the excitation coil, as a result of which a magnetic field in the excitable coil due to electromagnetic induction. An induced voltage is generated in the position detection coil in accordance with the magnetic field of the excitable coil, and the generated induced voltage is a detection signal representing the position of the movable member.

### Related Art Document

### Patent Document

Patent Document 1: Japanese Patent Application Laid-Open Publication No. H6-323803.
Document EP 0 259 488 B1 discloses a musical keyboard.
Document WO 2019 / 122 867 A1 discloses a keyboard sensor system.

### SUMMARY OF THE INVENTION

### Problems to be Solved by the Invention

The technique of Patent Document 1 is subjected to a drawback, however, in that in practice it is difficult to generate a magnetic field having sufficient strength for the excitable coil. Accordingly, it is not practically possible to secure a sufficient range of displacement of the movable member that makes an effective change of the level of the detection signal.

In view of the circumstances described above, an object of one aspect of the present disclosure is to secure with ease a range of displacement of a movable member that can make an effective change of the level of a detection signal.

### Means for Solving the Problems

To achieve the above-stated object, the present disclosure provides the features of the independent claims.

### BRIEF DESCRIPTION OF THE DRAWINGS

FIG.1 is a block diagram showing a configuration of a musical keyboard instrument according to a first embodiment.
FIG. 2 is a block diagram showing a configuration of the musical keyboard instrument.
FIG. 3 is a circuit diagram of a signal generator.
FIG. 4 is a circuit diagram of a detectable portion.
FIG. 5 is a block diagram showing a configuration of a signal processing circuit.
FIG. 6 is a plan view showing an example of a specific configuration of the detectable portion.
FIG. 7 is a cross-sectional view taken along line a-a in FIG. 6.
FIG. 8 is an illustration of a magnetic field generated in a first coil of the detectable portion.
FIG. 9 is a plan view showing an example of a specific configuration of the signal generator.
FIG. 10 is a cross-sectional view taken along line b-b in FIG. 9.
FIG. 11 is an illustration of a magnetic field generated in a second coil of the signal generator.
FIG. 12 is a disassembled perspective view showing a configuration of a detectable portion according to a second embodiment.
FIG. 13 is a plan view of the detectable portion according to the second embodiment.
FIG. 14 is a plan view of the detectable portion according to the second embodiment.
FIG. 15 is a cross-sectional view taken along line c-c in FIG. 14.
FIG. 16 is a plan view of a detectable portion according to a third embodiment.
FIG. 17 is a plan view of the detectable portion according to a third embodiment.
FIG. 18 is a plan view of a detectable portion according to a fourth embodiment.
FIG. 19 is a plan view of a detectable portion according to a fifth embodiment.
FIG. 20 is a cross-sectional view taken along line d-d in FIG. 19.
FIG. 21 is a schematic diagram showing a configuration of a detection system according to a modification.
FIG. 22 is a schematic diagram showing a configuration of a detection system according to the modification.
FIG. 23 is a perspective view showing a configuration of a support and a fixing member according to the modification.
FIG. 24 is a plan view of a detectable portion according to the modification.
FIG. 25 is a plan view of a detectable portion according to the modification.
FIG. 26 is a plan view of a detectable portion according to the modification.

### MODES FOR CARRYING OUT THE INVENTION

### A: First Embodiment

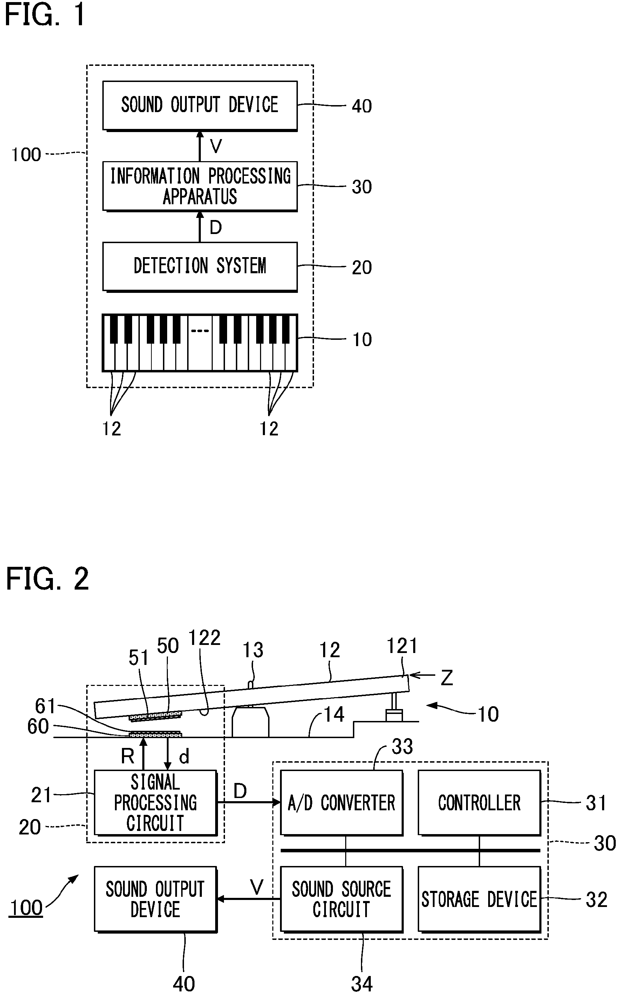

FIG. 1 is a block diagram showing a configuration of a musical keyboard instrument 100 according to a first embodiment of the present disclosure. The musical keyboard instrument 100 is an electronic musical instrument including a keyboard 10, a detection system 20, an information processing apparatus 30, and a sound output device 40. The keyboard 10 comprises keys 12 including black and white keys. The keys 12 are each movable members that are displaced by a playing operation of a user. The detection system 20 detects displacement of each of the keys 12. The information processing apparatus 30 generates an audio signal V in accordance with a detection result made by the detection system 20. The audio signal V is a signal representative of a music sound with a pitch that corresponds to one of the keys 12 operated by the user. The sound output device 40 outputs sound represented by the audio signal V. The sound output device 40 is a speaker or a headphone, for example.

FIG. 2 is a block diagram showing a specific configuration of the musical keyboard instrument 100, focusing on one of the keys 12 of the keyboard 10. Each of the keys 12 of the keyboard 10 is supported by a supporting member 14 by way of the supporter (balance pin) 13 that acts as a fulcrum. The supporting member 14 is a structure (frame) that supports each element of the musical keyboard instrument 100. The end 121 of each key 12 is displaced vertically by pressing and releasing keys by a user. The detection system 20 generates a detection signal D at a level depending on a vertical position Z of the end 121 for each of the keys 12. The position Z is expressed by an amount of displacement of the end 121, relative to a rest position of the end 121 in a released state in which no load is applied to the key 12.

The detection system 20 includes a detectable portion 50, a signal generator 60 and a signal processing circuit 21. The detectable portion 50 and the signal generator 60 are disposed for each key 12. The signal generator 60 is disposed on the supporting member 14. The detectable portion 50 is disposed on the key 12. Specifically, the detectable portion 50 is disposed on a bottom surface of the key 12 (hereinafter, "mounting surface") 122. The detectable portion 50 includes a first coil 51. The signal generator 60 includes a second coil 61. The first coil 51 and the second coil 61 oppose each other, and are vertically spaced apart from each other. A distance between the signal generator 60 and the detectable portion 50 (a distance between the first coil 51 and the second coil 61) changes depending on the position Z of the end 121 of the key 12.

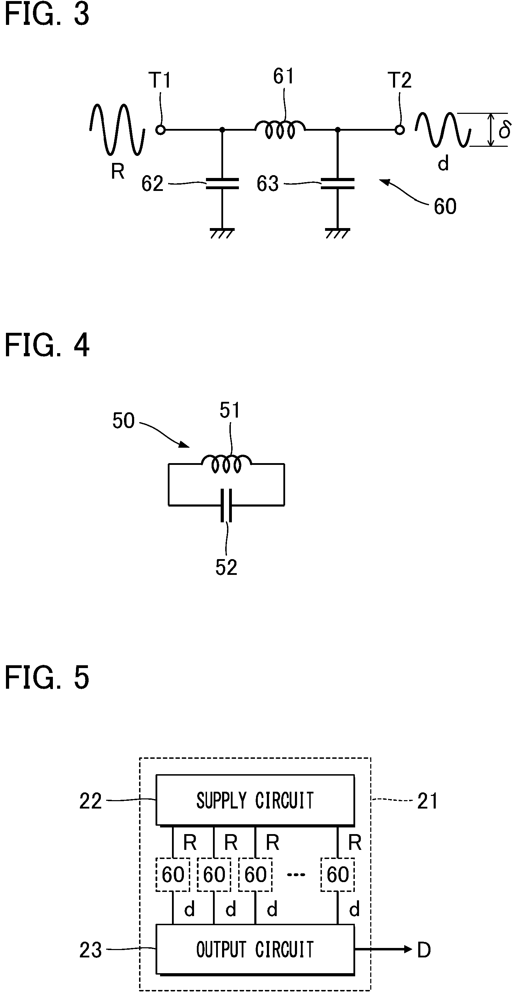

FIG. 3 is a circuit diagram showing an electrical configuration of the signal generator 60. The signal generator 60 includes a resonant circuit including an input T1, an output T2, a second coil 61, a capacitive element 62, and a capacitive element 63. The second coil 61 is wired between the input T1 and the output T2. The capacitive element 62 is wired between the input T1 and a ground wire. The capacitive element 63 is wired between the output T2 and the ground wire. The signal generator 60 acts as a low-pass filter that reduces low-pass components of a signal supplied to the input T1.

FIG. 4 is a circuit diagram showing an electrical configuration of the detectable portion 50. The detectable portion 50 includes a resonance circuit including a first coil 51 and a capacitive element 52. Both ends of the first coil 51 and both ends of the capacitive element 52 are wired to each other. The resonant frequency of the detectable portion 50 is the same for the signal generator 60, but it need not be.

The signal processing circuit 21 shown in FIG. 2 generates a detection signal D at a level depending on the distance between the first coil 51 and the second coil 61.

FIG. 5 is a block diagram showing a specific configuration of the signal processing circuit 21. The signal processing circuit 21 includes a supply circuit 22 and an output circuit 23. The supply circuit 22 supplies a reference signal R to each of the signal generators 60. The reference signal R is a current signal or a voltage signal, a level of which changes periodically. The reference signal R may be a cyclic signal of a freely selected waveform, such as a sine wave. The supply circuit 22 supplies the signal generators 60 with a reference signal R by time division. Specifically, the supply circuit 22 is a demultiplexer, which selects each of the signal generators 60 one by one, and supplies the reference signal R to the selected signal generator 60. Thus, the reference signal R is supplied to each of the signal generators 60 by time division. It is of note that the cycle of the reference signal R is sufficiently shorter than a period during which the supply circuit 22 selects one signal generator 60. Furthermore, the frequency of the reference signal R is substantially identical to the resonance frequencies of the detectable portion 50 and the signal generator 60, but it need not be.

As shown in FIG. 3, the reference signal R is supplied to the input T1 of the signal generator 60. A current in accordance with the reference signal R is supplied to the second coil 61, which generates a magnetic field in the second coil 61. The electromagnetic induction generated by the magnetic field in the second coil 61 causes an induced current in the first coil 51. As a result, a magnetic field, which has a direction such that change in the magnetic field in the second coil 61 is cancelled, is generated in the first coil 51. Since the magnetic field in the first coil 51 changes depending on a distance between the first coil 51 and the second coil 61, a detection signal d with an amplitude level δ depending on the distance therebetween is output from the output T2 of the signal generator 60. The detection signal d is a cyclic signal the level of which fluctuates with the same cycle as that of the reference signal R.

The output circuit 23 in FIG. 5 generates a detection signal D by sequentially arranging on a time axis detection signals d that are sequentially output from each of the signal generators 60. The detection signal D is a voltage signal with amplitude levels δ, each of which is dependent on a distance between the first coil 51 and the second coil 61 in each of the respective keys 12. As described previously, the distance between the first coil 51 and the second coil 61 changes in conjunction with the position Z of each key 12. Accordingly, the detection signal D is a signal depending on different positions Z of the respective keys 12. The detection signal D generated by the output circuit 23 is supplied to the information processing apparatus 30.

The information processing apparatus 30 in FIG. 2 analyzes the detection signal D supplied from the signal processing circuit 21, to determine the position Z of each key 12. The information processing apparatus 30 is realized by a computer system that includes a controller 31, a storage device 32, an A/D converter 33 and a sound source circuit 34. The A/D converter 33 converts the detection signal D supplied from the signal processing circuit 21 from an analog signal to a digital signal.

The controller 31 comprises one or more processors for controlling each of elements of the musical keyboard instrument 100. For example, the controller 31 is constituted of one or more types among different types, such as a Central Processing Unit (CPU), a Sound Processing Unit (SPU), a Digital Signal Processor (DSP), a Field Programmable Gate Array (FPGA), or an Application Specific Integrated Circuit (ASIC).

The storage device 32 comprises one or more memories that store programs executed by the controller 31 and data used by the controller 31. The storage device 32 is constituted of, for example, a known recording medium, such as a magnetic recording medium or a semiconductor recording medium. The storage device 32 may comprise a combination of different types of recording media. The storage device 32 may be a portable recording medium detachable from the musical keyboard instrument 100, or may be an external recording medium (e.g., online storage), with which the musical keyboard instrument 100 can communicate.

The controller 31 analyzes the position Z of each key 12 by analyzing the detection signal D after conversion by the A/D converter 33. The controller 31 instructs the sound source circuit 34 to produce a music sound based on the position Z of each key 12. The sound source circuit 34 generates an audio signal V representative of the music sound as instructed by the controller 31. Thus, the sound source circuit 34 generates the audio signal V in accordance with the amplitude levels δ of the detection signal D. For example, the volume of the audio signal V is controlled in accordance with the amplitude levels δ. The audio signal V is supplied from the sound source circuit 34 to the sound output device 40, whereby a musical sound that corresponds to playing operations performed by a user (depression or release of each key 12) is output from the sound output device 40. Execution of the program stored in the storage device 32 allows for the controller 31 to realize the functions of the sound source circuit 34.

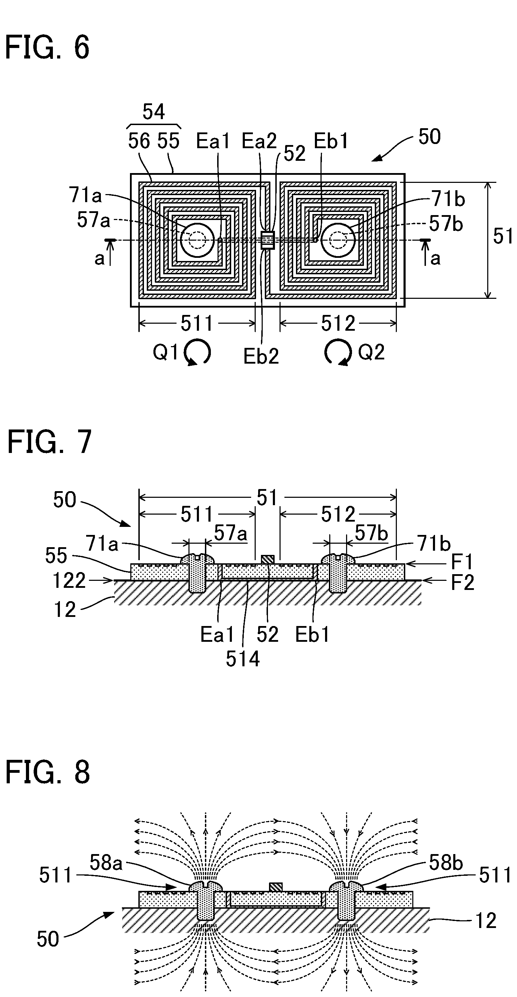

FIG. 6 is a plan view showing an example of a specific configuration of a detectable portion 50. In the plan view of FIG. 6, the detectable portion 50 is viewed from the signal generator 60. FIG. 7 is a cross-sectional view taken along line a-a in FIG. 6.

The detectable portion 50 according to the first embodiment comprises a wiring board 54 that includes a baseboard 55 and a wiring pattern 56. The baseboard 55 is a rectangular member that includes surfaces F1 and F2. The surface F2 opposes the mounting surface 122 of a key 12, and the surface F1 is opposite to the surface of the surface F2. Accordingly, the surface F1 opposes the signal generator 60. The baseboard 55 has a width smaller than one key 12.

The baseboard 55 has through-holes 57 (57a, 57b). Each through-hole 57 is a circular opening through the baseboard 55. The wiring board 54 is fixed to the mounting surface 122 of the key 12 using fixing members 71 (71a and 71b) for respective through-holes 57. Each fixing member 71 is a screw, and is inserted into the mounting surface 122. Specifically, the fixing member 71a is inserted into the through-hole 57a, and the fixing member 71b is inserted into the through-hole 57b. Each fixing member 71 is a magnetic body made of magnetic material, such as iron or ferrite.

The wiring pattern 56 is a conductive film provided on each of the surfaces (surfaces F1 and F2) of the baseboard 55. Specifically, the wiring pattern 56 is provided by patterning in which the conductive film that covers the entire surface of the baseboard 55 is selectively removed. The first coil 51 of the detectable portion 50 is composed of the wiring pattern 56. Thus, for example, as compared to a configuration in which the first coil 51 is wound by a conductive wire, it is easier to manufacture and handle the first coil 51.

The first coil 51 includes a first part 511 and a second part 512. The first part 511 and the second part 512 are provided on the surface F1, and these are in different areas when viewed from the vertical direction of the surface F1. Specifically, the first part 511 and the second part 512 are adjacent to each other along the longitudinal direction of the key 12.

The first part 511 surrounds through-hole 57a. Specifically, the first part 511 comprises a spiral winding that is wound clockwise from an end Ea1 of the inner circumference near the through-hole 57a to an end Ea2 at the outer circumference. The fixing member 71a overlaps the central axis of the first part 511, as seen in plan view. That is, the first part 511 surrounds the fixing member 71a, as seen in plan view. For this reason, the fixing member 71a acts as the core of the first part 511. However, the first part 511 does not overlap the head of the fixing member 71a inserted into the through-hole 57a, as seen in plan view.

The second part 512 surrounds the through-hole 57b. Specifically, the second part 512 comprises a spiral winding that is wound clockwise from an end Eb1 of the inner circumference near the through-hole 57b to an end Eb2 of the outer circumference. The fixing member 71b overlaps the central axis of the second part 512, as seen in plan view. That is, the second part 512 surrounds the fixing member 71b, as seen in plan view. For this reason, the fixing member 71b acts as the core of the second part 512. However, the second part 512 does not overlap the head of the fixing member 71b inserted into the through-hole 57b, as seen in plan view.

The wiring pattern 56 includes a connection wiring 514 provided on the surface F2 of the baseboard 55. The end portions Ea1 and Eb1 are connected to each other via the connection wiring 514. A capacitive element 52 is mounted on the surface F1, and is between the end Ea2 and the end Eb2.

As will be understood from the above description, the direction of the current flowing through the first part 511 opposes the direction of the current flowing through the second part 512. Specifically, when a current flows through the first part 511 in the direction Q1, a current flows through the second part 512 in the opposite direction Q2 of the direction Q1. As a result, as shown in FIG. 8, the first part 511 and the second part 512 are configured to generate opposite sense magnetic fields. That is, a magnetic field directed from the first part 511 to the second part 512, and vice versa, are generated. By the above configuration, it is possible to limit or reduce expansion of the magnetic fields over to and across different keys 12 adjacent to each other. Accordingly, it is possible to generate a detection signal D that highly accurately represents the position Z of each of the keys 12.

As explained above, in the first embodiment, the fixing members 71, which are magnetic bodies, are disposed on each of the keys 12. Accordingly, as compared to a configuration in which there is no magnetic body, magnetic fields generated in the first coil 51 are enhanced. That is, the range of displacement of a key 12, at which the magnetic fields in the first coil 51 significantly affect those in the second coil 61, is expanded. Thus, it is easy to secure the range of the displacement (detection stroke) of the key 12 in which the amplitude level δ of the detection signal D is effectively changed. In the first embodiment, in particular, the fixing members 71 for fixing the wiring board 54 to the key 12 are magnetic bodies. Accordingly, as compared to a configuration in which the wiring board 54 is fixed to the key 12 by use of other members, which differ from the magnetic bodies for enhancing magnetic fields in the first coil 51, the configuration of the detection system 20 is simplified. Furthermore, since the fixing members 71 are inserted into the through-holes 57 of the wiring board 54, the wiring board 54 can be fixed to the key 12 with a simple configuration.

In the first embodiment, the fixing member 71 overlaps the central axis of the first coil 51. Specifically, the fixing member 71a overlaps the central axis of the first part 511, and the fixing member 71b overlaps the central axis of the second part 512. Accordingly, as compared to a configuration in which the fixing member 71 is sufficiently spaced apart from the first coil 51, the magnetic fields generated in the first coil 51 are enhanced, and the attained effect is remarkable.

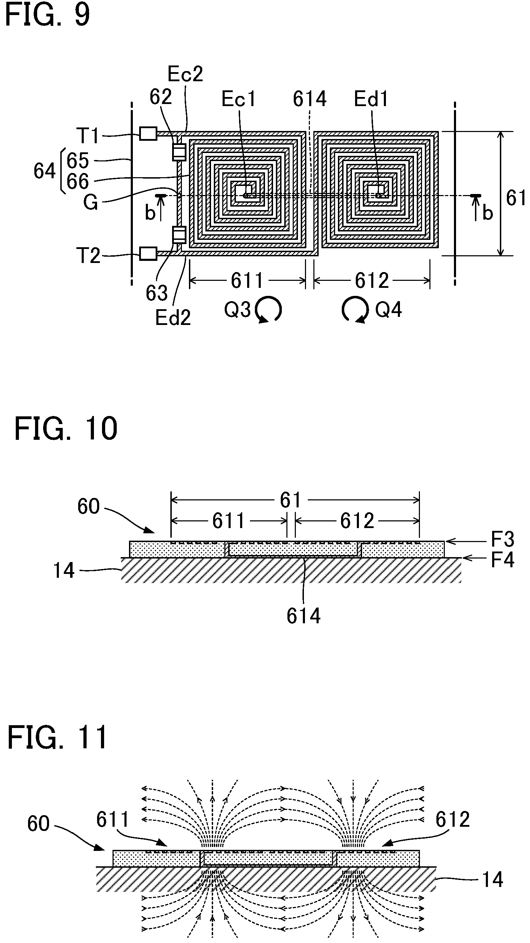

FIG. 9 is a plan view showing an example of a specific configuration of a signal generator 60. In FIG. 9, the signal generator 60 is viewed from the detectable portion 50. FIG. 10 is a cross-sectional view taken along line b-b in FIG. 9.

As shown in FIG. 9, the signal generator 60 comprises a wiring board 64 that includes a baseboard 65 and a wiring pattern 66. The baseboard 65 is a long plate member that extends over the keys 12, and it includes a surface F3 and a surface F4. The surface F4 opposes a supporting member 14, and the surface F3 is an opposing surface of the surface F4. Accordingly, the surface F3 opposes the detectable portion 50.

The wiring pattern 66 is a conductive film provided on each of the surfaces (surfaces F3 and F4) of the baseboard 65. Specifically, the wiring pattern 66 is provided by patterning in which that the conductive film that covers the entire surface of the baseboard 65 is selectively removed. The second coil 61 of the signal generator 60 is composed of the wiring pattern 66. Thus, for example, as compared to a configuration in which the second coil 61 is wound by a conductive wire, it is easier to manufacture and handle the second coil 61.

The second coil 61 includes a third part 611 and a fourth part 612. The third part 611 and the fourth part 612 are provided on the surface F3, and these are in different areas when viewed from the vertical direction of the surface F3. Specifically, the third part 611 and the fourth part 612 are adjacent to each other along the longitudinal direction of the key 12.

The third part 611 comprises a spiral winding that is wound counterclockwise from an end Ec1 of the inner circumference to an end Ec2 of the outer circumference. The fourth part 612 comprises a spiral winding that is wound counterclockwise from an end Ed1 of the inner circumference to an end Ed2 of the outer circumference. In a direction of the central axis of the second coil 61 (i.e., the vertical direction of the surface F3), a distance between the first coil 51 and the second coil 61 changes depending on position Z of the key 12.

The wiring pattern 66 includes a connection wiring 614 provided on the surface F4 of the baseboard 65. The ends Ec1 and Ed1 are connected to each other via the connection wiring 614. In addition, an input T1 and an output T2 are provided on the surface F3. The capacitive element 62 is wired between the input T1 and the end Ec2 of the third part 611. The capacitive element 63 is wired between the output T2 and the end Ed2 of the fourth part 612. The wiring for connecting the capacitive element 62 and the capacitive element 63 to each other is wired to a ground point G that is set to the ground potential.

As will be understood from the above description, the direction of the current flowing through the third part 611 is opposite to the direction of the current flowing through the fourth part 612. Specifically, when a current flows through the third part 611 in the direction Q3, a current flows through the fourth part 612 in the opposite direction Q4 of the direction Q3. As a result, as shown in FIG. 11, the third part 611 and the fourth part 612 are configured to generate opposite sense magnetic fields. That is, a magnetic field directed from the third part 611 to the fourth part 612, and vice versa, are generated. By the above configuration, it is possible to limit or reduce diffusion of the magnetic fields over to and across different keys 12 adjacent to each other. Therefore, it is possible to generate a detection signal D that highly accurately represents the position Z of each of the keys 12.

In the first embodiment, in the direction of the central axis of the second coil 61, the distance between the first coil 51 and the second coil 61 changes in accordance with the displacement of the key 12. Thus, as compared to a configuration in which the first coil 51 and the second coil 61 are movable relatively to each other in a plane perpendicular to the central axis of the second coil 61, it is possible to change the level of the detection signal D significantly in response to the displacement of the key 12.

### B: Second Embodiment

The second embodiment will be described below. It is to be noted that in each of the embodiments described below, like reference signs are used for elements having functions or effects identical to those of elements described in the first embodiment, and detailed explanations of such elements are omitted as appropriate.

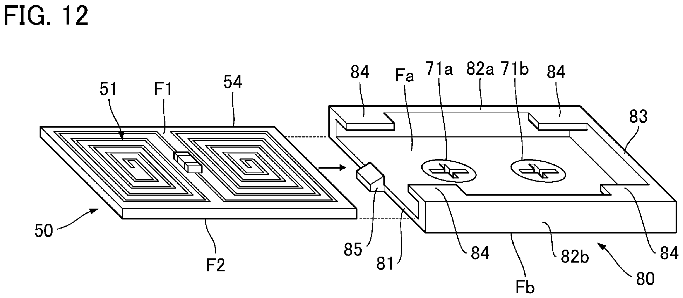

FIG. 12 is a perspective view showing a configuration of a detectable portion 50 according to the second embodiment. In the first embodiment, the wiring board 54 included in each detectable portion 50 is directly fixed to the mounting surface 122 by the fixing members 71. The detectable portion 50 according to the second embodiment includes a wiring board 54 and a support 80. The support 80 is fixed to the mounting surface 122 of the key 12. The wiring board 54 is on the support 80.

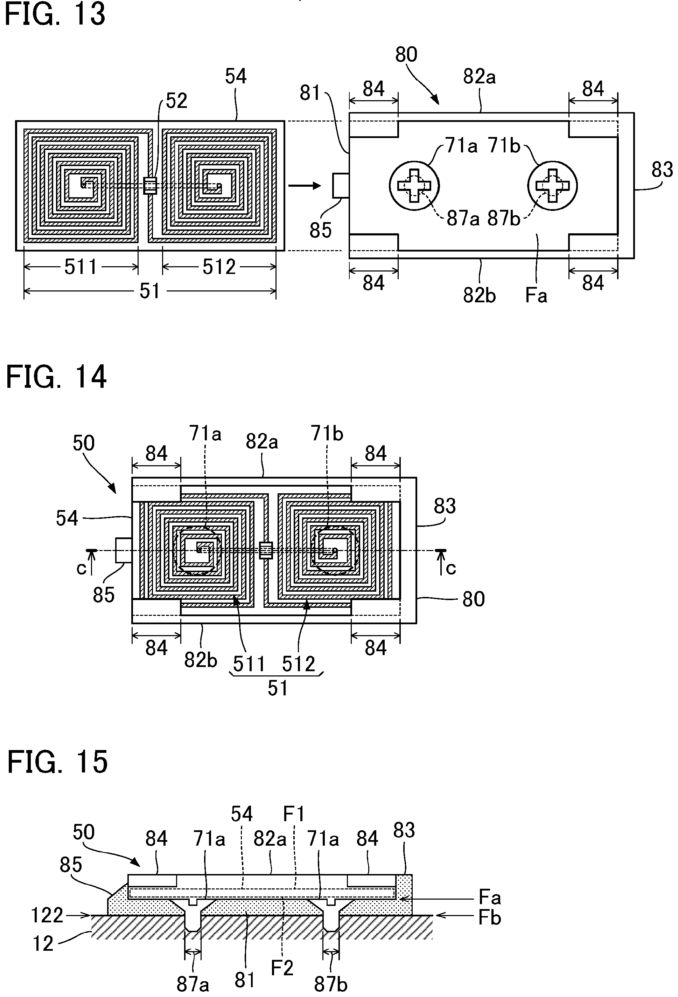

FIG. 13 is a plan view showing an example of a state in which the wiring board 54 is detached from the support 80. FIG. 14 is a plan view showing an example of a state in which the wiring board 54 is on the support 80. FIG. 15 is a cross-sectional view taken along line c-c in FIG. 14.

As shown in FIGs 12 to 14, the support 80 is a flat and box-shaped structure configured to support the wiring board 54. The material of the support 80 and manufacturing method thereof are freely selectable. For example, the support 80 is formed by injection molding of resin. Specifically, the support 80 includes a bottom 81, a side wall 82a, a side wall 82b, and a rear wall 83.

The bottom 81 is flat, and includes a holding surface Fa and a mounting surface Fb. The bottom 81 is rectangular, the shape of which corresponds to the outer of the wiring board 54. The mounting surface Fb opposes the mounting surface 122. The holding surface Fa is an opposing surface of the mounting surface Fb. The side walls 82a and 82b, and the rear wall 83 protrude from the holding surface Fa, and they are along the periphery of the bottom 81. The side walls 82a and 82b are opposite each other, and the rear wall 83 extends from the side wall 82a to the side wall 82b. The wiring board 54 is housed in the space enclosed by the holding surface Fa of the bottom 81, and three sides: the side wall 82a, the side wall 82b, and rear wall 83. As shown in FIG. 15, when the wiring board 54 is housed in the support 80, the surface F2 opposes the holding surface Fa.

There are protrusions 84 on each of the side walls 82a and 82b. Each protrusion 84 protrudes from the inner surface of the side wall 82a or 82b. Each protrusion 84 opposes the holding surface Fa of the bottom 81, and has a slight spacing from the holding surface Fa that is thicker than the thickness of the wiring board 54 (the baseboard 55). As shown in FIG. 15, the wiring board 54 is held between each protrusion 84 and the holding surface Fa.

A holding protrusion 85 is provided at an edge of the bottom 81 on the opposite of the rear wall 83. The holding protrusion 85 protrudes from the holding surface Fa. The wiring board 54 is inserted through the opening between the side walls 82a and 82b. At this time, the wiring board 54 is slid until one end of the wiring board 54 reaches the inner surface of the rear wall 803. When the end of the wiring board 54 is in contact with the inner surface of the rear wall 83, the holding protrusion 85 opposes the other end of the wiring board 54. That is, the wiring board 54 is held between the holding protrusion 85 and the rear wall 83. As will be understood from the above description, the holding protrusion 85 is a check claw by which the wiring board 54 is hooked by the end of the wiring board 54 to hold the wiring board 54. The wiring board 54 is attachable to and is detachable from the support 80. Accordingly, the wiring board 54 can be replaced with ease, as compared to a configuration in which the wiring board 54 is directly fixed to the mounting surface 122.

There are through-holes 87 (87a and 87b) on the bottom 81 of the support 80. Each through-hole 87 is a circular opening through the bottom 81. As shown in FIG. 15, the support 80 is fixed to the mounting surface 122 of the key 12 by the fixing members 71 (71a and 71b) that penetrate the respective through-holes 87. Each fixing member 71 is a screw, and it is inserted into the mounting surface 122. Specifically, the fixing member 71a is inserted into the through-hole 87a, and the fixing member 71b is inserted into the through-hole 87b. As in the first embodiment, each fixing member 71 is a magnetic body made of magnetic material, such as iron or ferrite. When the fixing members 71 are inserted into the respective through-holes 87, the top of the fixing member 71 and the holding surface Fa of the bottom 81 are located in the same plane.

As in the first embodiment, the first coil 51 is provided on the wiring board 54 according to the second embodiment. However, there are no through-holes 57 in the wiring board 54 according to the second embodiment. Accordingly, in the second embodiment, as compared to the first embodiment in which the through-holes 57 are provided on the wiring board 54, it is easier to secure the region for provision of the first coil 51. That is, the wiring width of the first coil 51 and number of turns thereof can be easily secured.

As in the first embodiment, the first coil 51 includes a first part 511 and a second part 512. As shown in FIG. 14, the fixing member 71a inserted into the through-hole 87a overlaps the central axis of the first part 511 of the first coil 51, as seen in plan view. Accordingly, the fixing member 71a acts as the core of the first part 511. Similarly, the fixing member 71b inserted into the through-hole 87b overlaps the central axis of the second part 512 of the first coil 51. Accordingly, the fixing member 71b acts as the core of the second part 512.

In the second embodiment, the same effects of the first embodiment are achieved. Furthermore, in the second embodiment, the fixing members 71, which are used to fix the support 80 on the wiring board 54 to the key 12, are magnetic bodies. Accordingly, as compared to a configuration in which the support 80 is fixed to the key 12 by use of other members, which differ from the magnetic bodies for enhancing magnetic fields in the first coil 51, the configuration of the detection system 20 is simplified. Furthermore, since the fixing members 71 are inserted into the respective through-holes 87 of the support 80, the support 80 can be fixed to the key 12 with a simple configuration.

### C: Third Embodiment

In the first and second embodiments, an example has been described of a configuration in which the first coil 51 is provided on the surface F1 of the baseboard 55. In the third embodiment, the first coil 51 is configured by stacked multiple wiring patterns 56.

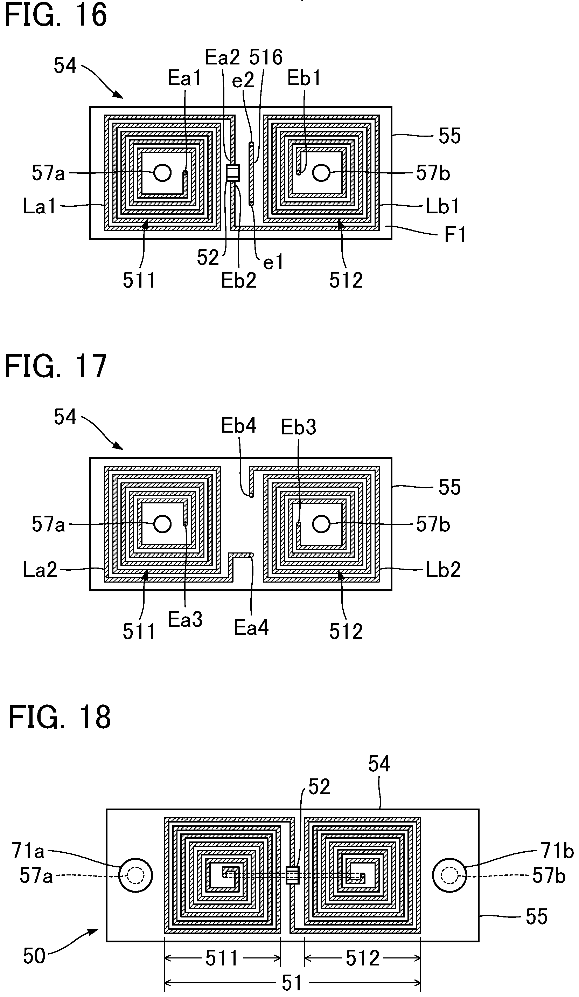

FIGs. 16 and 17 are each a plan view showing a configuration of the wiring board 54 according to the third embodiment. In FIG. 16, wirings are shown on the surface F1, and in FIG. 17, wirings are shown on the surface F2. However, in the wirings on the surface F2 in FIG. 17, the outline viewed from the surface F1 is shown for convenience.

The first part 511 of the first coil 51 comprises a first layer La1 and a second layer La2. The first layer La1 is provided on the surface F1, and the second layer La2 is provided on the surface F2. The first layer La1 comprises a spiral winding that is wound from an end Ea1 of the inner circumference to an end Ea2 of the outer circumference. The second layer La2 comprises a spiral winding that is wound from an end Ea3 of the inner circumference to an end Ea4 of the outer circumference. The ends Ea1 and Ea3 are mutually connected through respective conductive holes provided on the baseboard 55.

The second part 512 of the first coil 51 comprises a first layer Lb1 and a second layer Lb2. The first layer Lb1 is provided on the surface F1, and the second layer Lb2 is provided on the surface F2. The first layer Lb1 comprises a spiral winding that is wound from an end Eb1 of the inner circumference to an end Eb2 of the outer circumference. The second layer Lb2 comprises a spiral winding that is wound from an end Eb3 of the inner circumference to an end Eb4 of the outer circumference. The ends Eb1 and Eb3 are connected to each other through respective conductive holes provided on the baseboard 55. The end Ea2 of the first layer La1 and the end portion Eb2 of the first layer Lb1 are wired to the capacitive element 52. This configuration is the same for the first embodiment.

The relay wiring 516 is provided on the surface F1. The relay wiring 516 is a straight wire, and it extends from the end E1 to the end E2. The end Ea4 of the second layer La2 of the first part 511 is wired to an end E1 of the relay wiring 516. The end Eb4 of the second layer Lb2 of the second part 512 is wired to an end e2 of the relay wiring 516.

According to the above configuration, currents in the same direction flow through the first layer La1 and the second layer La2 of the first part 511. Currents in the same direction flow through the first layer Lb1 and the second layer Lb2 of the second part 512. The direction of the current flowing through the first part 511 is opposites to the direction of the current flowing through the second part 512.

In the third embodiment, the same effects of the first embodiment are achieved. In Figs. 16 and 17, an example has been described of an aspect based on the wiring board 54 having the through-holes 57 according to the first embodiment. However, the same configuration is applied to the wiring board 54 having no through holes 57 according to the second embodiment. In the above description, the first coil 51 is configured by the stacked two layers, but the number of layers of the first coil 51 may be three or more.

### D: Fourth Embodiment

FIG. 18 is a plan view showing an example of a configuration of a detectable portion 50 according to a fourth embodiment. The detectable portion 50 according to the fourth embodiment is composed of a wiring board 54, as in the first embodiment. In the first embodiment, an example has been described of a configuration in which each of the fixing members 71 overlaps the corresponding central axis of the first coil 51. In the fourth embodiment, the fixing members 71 (71a and 71b) do not overlap the corresponding central axis of the first coil 51. The configuration in which the fixing members 71 are magnetics bodies is the same for the first embodiment.

Specifically, the through-hole 57a and the fixing member 71a are positioned closer to the first part 511 than the second part 512. Similarly, the through-hole 57b and the fixing member 71b are positioned closer to the second part 512 than the first part 511. That is, the first coil 51 is disposed between the fixing members 71a and 71b.

In the fourth embodiment, the fixing members 71, which are magnetic bodies, are disposed on the key 12. Accordingly, as in the first embodiment, as compared to a configuration in which there is no magnetic body, magnetic fields generated in the first coil 51 are enhanced. Thus, it is easy to secure the range of the displacement (detection stroke) of the key 12 in which the amplitude level δ of the detection signal D is effectively changed.

### E: Fifth Embodiment

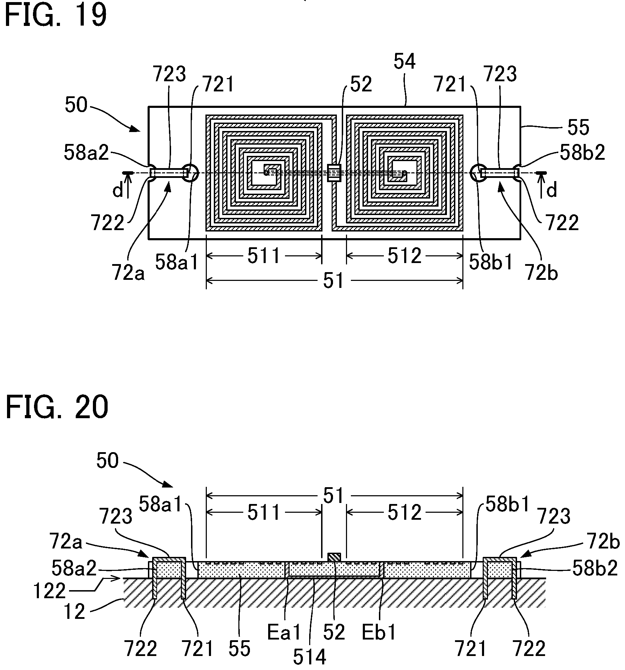

FIG. 19 is a plan view showing an example of a configuration of a detectable portion 50 according to a fifth embodiment. FIG. 20 is a cross-sectional view taken along line d-d in FIG. 19. In the fifth embodiment, fixing members 72 (72a and 72b) are used to fix the wiring board 54 to the mounting surface 122.

The fixing members 72 are staples, each of which is formed by a straight wire being bent in the same direction at two points. Specifically, each of the fixing members 72 includes a first staple part 721, a second staple part 722, and a connection part 723. The first staple part 721 and the second staple part 722 are spaced apart from each other, and they are parallel. An end of the first staple part 721 is connected to an end of the second staple part 722 by the connection part 723. The fixing members 72 are magnetic bodies made of magnetic material, such as iron or ferrite.

The baseboard 55 has mounting holes 58 (58a1, 58a2, 58b1 and 58b2). Each mounting hole 58 is an opening through the baseboard 55. The mounting holes 58a1 and 58b1 are circular, as seen in plan view. The mounting holes 58a2 and 58b2 are semicircular notches, and are provided at an edge of the baseboard 55. The mounting hole 58a1 and the mounting hole 58a2 are positioned closer to the first part 511 than the second part 512. The mounting hole 58b1 and the mounting hole 58b2 are positioned closer to the second part 512 than the first part 511.

The fixing members 72 are driven into the mounting surface 122 through the mounting holes 58 to fix the wiring board 54 to the mounting surface 122. Specifically, the first staple part 721 of the fixing member 72a is driven into the mounting surface 122 through the mounting hole 58a1. The second staple part 722 of the fixing member 72a is driven into the mounting surface 122 through the mounting hole 58a2. Furthermore, the first staple part 721 of the fixing member 72b is driven into the mounting surface 122 through the mounting hole 58b1. The second staple part 722 of the fixing member 72b is driven into the mounting surface 122 through the mounting hole 58b2.

In the fifth embodiment, the fixing members 72, which are magnetic bodies, are disposed on the key 12. Accordingly, as in the first embodiment, as compared to a configuration in which there is no magnetic body, magnetic fields generated in the first coil 51 are enhanced. Thus, it is easy to secure the range of the displacement (detection stroke) of the key 12 in which the amplitude level δ of the detection signal D is effectively changed.

In the first embodiment (see FIG. 6), the second embodiment (see FIG. 14) and the third embodiment (see FIG. 16), the fixing members 71 are positioned inner to the first coil 51, as seen in plan view. The "inner to the first coil 51" refers to an inside of the closed area surrounded by the outer circumference of the first coil 51.

In contrast, in the fourth embodiment (see FIG. 18) and the fifth embodiment (see FIG. 19), the fixing members (71 and 72) are positioned outer to the first coil 51, as seen in plan view. The outer to the first coil 51 refers to an outside of the closed area surrounded the outer circumference of the first coil 51.

### F: Modifications

Specific modifications added to each of the aspects described above are described below. Two or more modes selected from the following descriptions may be combined with one another as appropriate as long as such combination does not give rise to any conflict.
(1) Each of the above embodiments describes a configuration for detecting the displacement of the key 12 in the musical keyboard instrument 100. However, a movable member, of which the displacement is detected by the detection system 20, is not limited to the key 12. Specific modes of the movable member are described below.

### Mode A

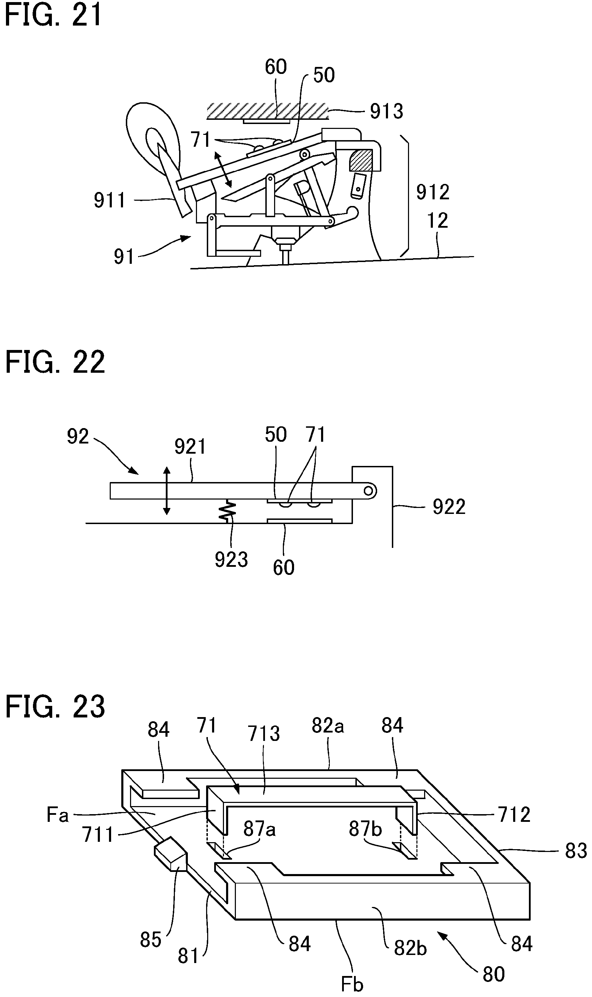

FIG. 21 is a schematic diagram of a configuration in which the detection system 20 is applied to a strike mechanism 91 of the musical keyboard instrument 100. As in an acoustic piano, the strike mechanism 91 is a mechanism that strikes a string (not shown) in conjunction with a displacement of each key 12 in the keyboard 10.
Specifically, the strike mechanism 91 includes, for each key 12, a hammer 911 capable of striking a string by rotation and a transmission mechanism 912 (e.g., a whippen, jack, repetition lever, etc.) that causes the hammer 911 to rotate in conjunction with the displacement of the key 12. By the above configuration, the detection system 20 detects displacement of the hammer 911. Specifically, the detectable portion 50 is disposed on the hammer 911 (e.g., at a hammer shank). For example, the wiring board 54, which comprises the detectable portion 50, is fixed to the hammer 911 by the fixing members 71 that are magnetic bodies. In contrast, the signal generator 60 is disposed on the supporting member 913. The supporting member 913 is a structure configured to support, for example, the strike mechanism 91. As in the second embodiment, the wiring board 54 may be disposed on the hammer 911 via the support 80. The detectable portion 50 may be disposed on a member of the strike mechanism 91 other than the hammer 911.

### Mode B

FIG. 22 is a schematic diagram of a configuration in which the detection system 20 is applied to a pedal mechanism 92 of the musical keyboard instrument 100. The pedal mechanism 92 includes a pedal 921 operated by a user's foot, a supporting member 922 that supports the pedal 921, and an elastic body 923 that urges the pedal 921 in the upward vertical direction. By the above configuration, the detection system 20 detects the displacement of the pedal 921. Specifically, the detectable portion 50 is disposed on the bottom of the pedal 921. That is, the wiring board 54, which comprises the detectable portion 50, is fixed to the pedal 921 by the fixing members 71 that are magnetic bodies. The signal generator 60 is disposed on the supporting member 922 such that the signal generator 60 opposes the detectable portion 50.

As in the second embodiment, the wiring board 54 may be disposed on the pedal 921 via support 80. A musical instrument for which the pedal mechanism 92 is used is not limited to the musical keyboard instrument 100. For example, the pedal mechanism 92 of the same configuration may be used in a freely selected musical instrument, such as a percussion instrument, etc.

As will be understood from the above examples, an object of detection by the detection system 20 is a movable member that is displaced in response to a playing operation. The movable member includes an instrument operating element, such as the keys 12 or the pedal 921, directly operated by a user and also includes a structure such as the hammer 911 that is displaced in conjunction with an operation performed on an instrument playing element. However, the movable member according to the present disclosure is not limited to a member that is displaced in response to a playing operation. That is, the movable member should be understood as a displaceable member regardless of how displacement takes place.

(2) In each of the above embodiments, screws are given as an example the fixing members 71, but the embodiments of the fixing members 71 are not limited to the above examples. For example, nails or bolts may be used as the fixing members 71. Furthermore, a fixing member 71 (i.e., staple) shown in FIG. 23 may be used to fix the support 80. The fixing member 71 shown in FIG. 23 includes an insertion part 711, an insertion part 712, and a connection part 713. The insertion parts 711 and 712 are connected to each other by the connection part 713. The insertion part 711 is inserted into the mounting surface 122 of the key 12 through a through-hole 87a. The insertion part 712 is inserted into the mounting surface 122 through a through-hole 87b. In FIG. 23, the configuration in which the support 80 is fixed is shown. However, the wiring board 54 may be directly fixed to the mounting surface 122 using the fixing member 71 shown in FIG. 23.

(3) In each of the above embodiments, the fixing members 71 for fixing the detectable portion 50 are used as magnetic bodies for enhancing magnetic fields in the first coil 51. However, there may be disposed magnetic bodies that differ from the fixing members 71. That is, the magnetic bodies for enhancing magnetic fields in the first coil 51 may not have a function of fixing the detectable portion 50.

(4) In each of the above embodiments, there is shown a configuration in which the musical keyboard instrument 100 includes the sound source circuit 34. However, the sound source circuit 34 may be omitted in a configuration in which the musical keyboard instrument 100 has a sound producing mechanism such as strike mechanism 91, for example. The detection system 20 is used to record how the musical keyboard instrument 100 is played. The sound producing mechanism and the sound source circuit 34 are a sound generator that generates sound in accordance with the results of the detection by the detection system 20.

As will be understood from the above description, the present disclosure may be considered to be an apparatus (instrument playing apparatus) that controls a music sound by outputting to the sound source circuit 34 or the sound producing mechanism an operation signal in accordance with a playing operation. The concept of the instrument playing apparatus includes not only an instrument (the musical keyboard instrument 100) provided with the sound source circuit 34 or the sound producing mechanism as described in each of the above embodiments, but also a device not provided with the sound source circuit 34 or a sound producing mechanism (e.g., a MIDI controller or the pedal mechanism 92 as described above). That is, the instrument playing apparatus according to the present disclosure is explained as an apparatus operated by an instrument player (or an operator) for playing an instrument.

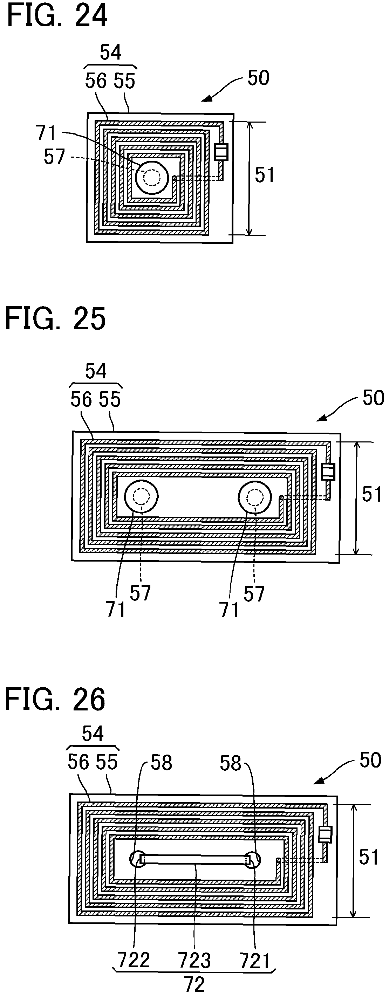

(5) In each of the above embodiments, an example has been described of a configuration in which the first coil 51 includes a first part 511 and a second part 512. However, the first coil 51 may not be configured by two coils. For example, as shown in FIG. 24, the first coil 51 may be configured by a single coil (e.g., either the first part 511 or the second part 512). In the configuration shown in FIG. 24, the first coil 51 is configured such that a fixing member 71 inserted into a through-hole 57 is surrounded by the first coil 51, as seen in plan view. As shown in FIG. 25, one first coil 51 may be disposed along the longitudinal direction of the key 12 such that fixing members 71 for fixing the wiring board 54 are surrounded by the first coil 51, as seen in plan view.

Furthermore, as shown in FIG. 26, a fixing member 72 according to the fifth embodiment may be disposed inner to the first coil 51, as seen in plan view. The configuration in which the first coil 51 is a single coil may be applied to the second to fourth embodiments. Similarly, the second coil 61 may not be configured by two coils (the third part 611 and the fourth part 612).

(6) In each of the above embodiments, an example has been described of a configuration in which a distance between the first coil 51 and the second coil 61 changes by a playing operation. Instead of this configuration, an area at which the first coil 51 opposes the second coil 61 (hereinafter, "opposing area") may change by a playing operation. The amplitude level δ of the detection signal d output from the signal generator 60 changes in response to the opposing area. As shown in the above examples, in the present disclosure, the opposing area or the distance between the first coil 51 and the second coil 61 changes by a playing operation.

(7) In each of the above embodiments, magnetic bodies (fixing members 71), each of which is an example of a movable member, are disposed on the key 12. However, the magnetic bodies may be disposed on the signal generator 60. For example, fixing members 14 for fixing the signal generator 60 (in particular, the baseboard 65), such as screws, are used as magnetic bodies. According to the configuration in which the magnetic bodies are disposed on the signal generator 60, magnetic fields generated in the second coil 61 are enhanced. Thus, it is easy to secure the range of displacement (detection stroke) of the key 12 in which the level of the detection signal D is effectively changed. Such an effect is the same as that of the foregoing embodiments. The foregoing configuration in which the magnetic bodies are disposed on the key 12 can apply to the magnetic bodies disposed on the signal generator 60.

In addition to the configuration in which the magnetic bodies are displaced on the key 12, additional magnetic bodies may be disposed on the signal generator 60. Alternatively, in addition to the magnetic bodies disposed in the key 12, additional magnetic bodies is disposed on the signal generator 60. That is, the magnetic bodies, such as the fixing members, may be disposed on at least one of the key 12 (movable member) or the signal generator 60.

### G: Appendices

The following configurations are derivable from the embodiments described above.

A detection system according to one aspect (Aspect 1) of the present disclosure is a detection system for detecting a displacement of a movable member in accordance with a playing operation, the detection system including: a detectable portion that is disposed on the movable member and includes a first coil; a signal generator configured to: include a second coil that generates a magnetic field by receiving a supply of a current, and generate a detection signal with a level depending on a distance between the detectable portion and the second coil; and a magnetic body that is disposed on at least one of the movable member or the signal generator.

By this configuration, an electromagnetic induction generated by the magnetic field in the second coil causes a current in the first coil. As a result, a magnetic field, which has a direction such that change in the magnetic field in the second coil is cancelled, is generated in the first coil. Accordingly, a detection signal with a level depending on the distance between the detectable portion and the second coil is generated by the signal generator. That is, a detection signal is generated in accordance with a displacement of the movable member.

The magnetic body is disposed on at least one of the movable member or the signal generator. Accordingly, as compared to a configuration in which there is no magnetic body, a magnetic field generated in the first coil or the second coil is enhanced. Thus, it is easy to secure the range of the displacement (detection stroke) of the movable member in which the amplitude level of the detection signal is effectively changed.

### Description of Reference Signs

100...musical keyboard instrument (instrument playing apparatus), 10...keyboard, 12...key, 20...detection system, 21...signal processing circuit, 22...supply circuit, 23...output circuit, 30... information processing apparatus, 31...controller, 32... storage device, 33...A/D converter, 34... sound source circuit, 40... sound output device, 50...detectable portion, 51...first coil, 511...first part, 512...second part, 52...capacitive element, 54...wiring board, 55...baseboard, 56...wiring pattern, 57 (57a and 57b)...through-hole, 58 (58a1, 58a2, 58b1 and 58b2)... mounting hole, 60...signal generator, 61...second coil, 62 and 63...capacitive element, 64... wiring board, 65...baseboard, 66... wiring pattern, 71(71a and 71b), and 72(72a and 72b)...fixing member, 80...support, 81...bottom, 82a and 82b...side wall, 83...rear wall, 84...protrusion, 85...holding protrusion, 87(87a and 87b)... through-hole, 91...strike mechanism, 911...hammer, 912... transmission mechanism, 913...supporting member, 92...pedal mechanism, 921...pedal, 922...supporting member, 923...elastic body.

## Claims

1. A detection system (20) for detecting a displacement of a movable member (12) in accordance with a playing operation, the detection system (20) comprising:
a detectable portion (50) that is disposed on the movable member (12) and includes a first coil (51);
a signal generator (60) configured to:
include a second coil (61) that generates a magnetic field by receiving a supply of a current, and
generate a detection signal with a level depending on a distance between the detectable portion (50) and the second coil (61); and
a magnetic body that is disposed on at least one of the movable member (12) or the signal generator (60);
**characterized in that**
the detectable portion (50) includes a wiring board on which the first coil (51) is provided, and
the magnetic body includes a fixing member for fixing the wiring board to the movable member (12).

2. The detection system (20) according to claim 1,
wherein the distance between the detectable portion (50) and the second coil (61) in a direction of a central axis of the second coil (61) changes in accordance with the displacement of the movable member (12).

3. The detection system (20) according to claim 1,
wherein the fixing member is configured to be inserted into a through-hole provided in the wiring board.

4. The detection system (20) according to claim 1,
wherein the detectable portion (50) further includes:
a wiring board on which the first coil (51) is provided; and
a support configured to support the wiring board, and
wherein the magnetic body includes a fixing member for fixing the support to the movable member (12).

5. The detection system (20) according to claim 4,
wherein the fixing member is configured to be inserted into a through-hole provided in the support.

6. The detection system (20) according to any one of claims 1 to 5,
wherein the first coil (51) is a wiring pattern on a surface of the wiring board.

7. The detection system (20) according to any one of claims 1 to 6,
wherein the first coil (51) includes a first part and a second part, and
wherein a direction of a current flowing through the first part is opposite to that of a current flowing through the second part.

8. The detection system (20) according to any one of claims 1 to 7,
wherein the second coil (61) includes a third part and a fourth part, and
wherein a direction of a current flowing through the third part is opposite to that of a current flowing through the fourth part.

9. The detection system (20) according to any one of claims 1 to 8,
wherein the magnetic body overlaps a central axis of the first coil (51).

10. The detection system (20) according to any one of claims 1 to 8,
wherein the magnetic body is positioned outer to the first coil (51), as seen from a central axis of the first coil (51).

11. An instrument playing apparatus (100) comprising:
a movable member (12) in accordance with a playing operation;
a detection system (20) according to any one of the preceding claims.

12. A musical keyboard instrument (100) comprising:
a key in accordance with a playing operation;
a detection system (20) according to any one of the preceding claims 1 to 10; and
a sound generator configured to generate sound in accordance with the detection signal generated by the detection system (20).

## Patentansprüche

1. Detektionssystem (20) zum Erfassen einer Verschiebung eines bewegbaren Elements (12) entsprechend einer Spieloperation, wobei das Detektionssystem (20) aufweist:
einen detektierbaren Abschnitt (50), der an dem bewegbaren Element (12) angeordnet ist und eine erste Spule (51) umfasst;
einen Signalgenerator (60), der konfiguriert ist, um:
eine zweite Spule (61) einzubeziehen, die ein Magnetfeld durch Zufuhr eines Stroms erzeugt, und
ein Detektionssignal mit einem Pegel in Abhängigkeit von einem Abstand zwischen dem detektierbaren Abschnitt (50) und der zweiten Spule (61) zu erzeugen; und
einen magnetischen Körper, der an mindestens einem des bewegbaren Elements (12) oder des Signalgenerators (60) angeordnet ist;
**dadurch gekennzeichnet, dass**
der detektierbare Abschnitt (50) eine Leiterplatte umfasst, auf der die erste Spule (51) vorgesehen ist, und
der magnetische Körper ein Befestigungselement zum Befestigen der Leiterplatte an dem bewegbaren Element (12) umfasst.

2. Detektionssystem (20) gemäß Anspruch 1,
wobei sich der Abstand zwischen dem detektierbaren Abschnitt (50) und der zweiten Spule (61) in Richtung einer Mittelachse der zweiten Spule (61) entsprechend der Verschiebung des bewegbaren Elements (12) ändert.

3. Detektionssystem (20) gemäß Anspruch 1,
wobei das Befestigungselement konfiguriert ist, um in eine Durchgangsbohrung eingeführt zu werden, die in der Leiterplatte vorgesehen ist.

4. Detektionssystem (20) gemäß Anspruch 1,
wobei der detektierbare Abschnitt (50) ferner umfasst:
eine Leiterplatte, auf der die erste Spule (51) vorgesehen ist; und
eine Stütze, die konfiguriert ist, um die Leiterplatte zu tragen, und
wobei der magnetische Körper ein Befestigungselement zum Befestigen der Stütze an dem bewegbaren Element (12) umfasst.

5. Detektionssystem (20) gemäß Anspruch 4,
wobei das Befestigungselement konfiguriert ist, um in eine Durchgangsbohrung eingeführt zu werden, die in der Stütze vorgesehen ist.

6. Detektionssystem (20) gemäß einem der Ansprüche 1 bis 5,
wobei die erste Spule (51) eine Leiterbahn auf einer Oberfläche der Leiterplatte ist.

7. Detektionssystem (20) gemäß einem der Ansprüche 1 bis 6,
wobei die erste Spule (51) einen ersten Abschnitt und einen zweiten Abschnitt umfasst, und
wobei eine Richtung eines Stroms, der durch den ersten Abschnitt fließt, entgegengesetzt zu der eines Stroms ist, der durch den zweiten Abschnitt fließt.

8. Detektionssystem (20) gemäß einem der Ansprüche 1 bis 7,
wobei die zweite Spule (61) einen dritten Abschnitt und einen vierten Abschnitt umfasst, und
wobei eine Richtung eines Stroms, der durch den dritten Abschnitt fließt, entgegengesetzt zu der eines Stroms ist, der durch den vierten Abschnitt fließt.

9. Detektionssystem (20) gemäß einem der Ansprüche 1 bis 8,
wobei der magnetische Körper eine Mittelachse der ersten Spule (51) überlappt.

10. Detektionssystem (20) gemäß einem der Ansprüche 1 bis 8,
wobei der magnetische Körper außerhalb der ersten Spule (51) positioniert ist, von einer Mittelachse der ersten Spule (51) aus gesehen.

11. Instrumentenspielvorrichtung (100), aufweisend:
ein bewegbares Element (12) entsprechend einer Spieloperation;
ein Detektionssystem (20) nach einem der vorhergehenden Ansprüche.

12. Musik-Tasteninstrument (100), aufweisend:
eine Taste entsprechend einer Spieloperation;
ein Detektionssystem (20) nach einem der Ansprüche 1 bis 10; und
einen Tongenerator, der konfiguriert ist, um Schall entsprechend dem von dem Detektionssystem (20) erzeugten Detektionssignal zu erzeugen.

## Revendications

1. Système de détection (20) pour détecter un déplacement d'un élément mobile (12) en fonction d'une opération de jeu, le système de détection (20) comprenant :
une partie détectable (50) disposée sur l'élément mobile (12) et comprenant une première bobine (51) ;
un générateur de signal (60) configuré pour :
inclure une seconde bobine (61) générant un champ magnétique par réception d'un courant d'alimentation, et
générer un signal de détection dont le niveau dépend d'une distance entre la partie détectable (50) et la seconde bobine (61) ; et
un corps magnétique disposé sur au moins l'un parmi l'élément mobile (12) ou le générateur de signal (60) ;
**caractérisé en ce que**
la partie détectable (50) comprend un circuit imprimé sur lequel la première bobine (51) est disposée, et
le corps magnétique comprend un élément de fixation pour fixer le circuit imprimé à l'élément mobile (12).

2. Système de détection (20) selon la revendication 1,
dans lequel la distance entre la partie détectable (50) et la seconde bobine (61) dans une direction d'un axe central de la seconde bobine (61) varie en fonction du déplacement de l'élément mobile (12).

3. Système de détection (20) selon la revendication 1,
dans lequel l'élément de fixation est configuré pour être inséré dans un trou traversant pratiqué dans le circuit imprimé.

4. Système de détection (20) selon la revendication 1,
dans lequel la partie détectable (50) comprend en outre :
un circuit imprimé sur lequel la première bobine (51) est disposée ; et
un support configuré pour supporter le circuit imprimé, et
dans lequel le corps magnétique comprend un élément de fixation pour fixer le support à l'élément mobile (12).

5. Système de détection (20) selon la revendication 4,
dans lequel l'élément de fixation est configuré pour être inséré dans un trou traversant pratiqué dans le support.

6. Système de détection (20) selon l'une quelconque des revendications 1 à 5,
dans lequel la première bobine (51) est un motif de circuit sur une surface du circuit imprimé.

7. Système de détection (20) selon l'une quelconque des revendications 1 à 6,
dans lequel la première bobine (51) comprend une première partie et une seconde partie, et
dans lequel une direction d'un courant traversant la première partie est opposée à celle d'un courant traversant la seconde partie.

8. Système de détection (20) selon l'une quelconque des revendications 1 à 7,
dans lequel la seconde bobine (61) comprend une troisième partie et une quatrième partie, et
dans lequel une direction d'un courant traversant la troisième partie est opposée à celle d'un courant traversant la quatrième partie.

9. Système de détection (20) selon l'une quelconque des revendications 1 à 8,
dans lequel le corps magnétique chevauche un axe central de la première bobine (51).

10. Système de détection (20) selon l'une quelconque des revendications 1 à 8,
dans lequel le corps magnétique est positionné à l'extérieur de la première bobine (51), vu depuis un axe central de la première bobine (51).

11. Appareil de jeu d'instrument (100) comprenant :
un élément mobile (12) en fonction d'une opération de jeu ;
un système de détection (20) selon l'une quelconque des revendications précédentes.

12. Instrument à clavier musical (100) comprenant :
une touche en fonction d'une opération de jeu ;
un système de détection (20) selon l'une quelconque des revendications 1 à 10 ; et
un générateur de son configuré pour générer un son en fonction du signal de détection généré par le système de détection (20).
